# EUROPEAN PATENT APPLICATION

(11) **EP 2 624 267 A1**
(43) Date of publication of application: **07.08.2013**
(21) Application number: 11748867.6
(22) Date of filing: 22.03.2011
(51) Int. Cl.: H01G 9/00

(54) **ELECTROLYTIC CAPACITOR SOCKET**

(30) Priority: 29.09.2010 JP 2010218607
(71) Applicant: Omron Corporation, Kyoto-shi, Kyoto 600-8530 (JP)
(72) Inventor: SHIMIZU, Ryoji, Kyoto-shi, Kyoto 600-8530 (JP); SATO, Makoto, Kyoto-shi, Kyoto 600-8530 (JP)
(74) Representative: Kilian Kilian & Partner
(86) International application number: PCT/JP2011/056714
(87) International publication number: WO 2012/042936

(57) **Abstract**

The invention is to prevent any reduction of a force for holding an electrolytic capacitor even when an internal pressure is increased and increase an effectiveness of repetitive use of an electric circuit used therewith. For this purpose, a socket 11 for electrolytic capacitors has a support 12 for supporting a bottom surface of the capacitor 61 having a housing 62 and leads 63, 64 provided at the bottom surface thereof, the support surface 12 comprising connecting terminals 31 for electrically connecting the leads 63, 64 to a circuit substrate 51. The support 12 comprises a holder 13 formed therewith for releasably holding a portion of capacitor 61, adjacent the leads 63, 64, and a recess 14 formed therein for accommodating deformations of seal rubber 65 provided at the housing 62 of the capacitor 61.

## Description

### TECHNICAL FIELD

The present invention relates to a socket for electrolytic capacitors and, more specifically, the present invention relates to a socket for electrolytic capacitors, by which relatively short-lived electrolytic capacitors can be replaced by new ones and an electric circuit can also be used with the newly replaced electrolytic capacitors.

### BACKGROUND OF THE INVENTION

Typically, the electrolytic capacitor is incorporated in, for example, a smoothing circuit, together with circuit components.

The circuit components can be used for a long time. Contrarily, the life of the electrolytic capacitor is relatively short. In particular, a life of the low capacitance capacitor is shorter than that of high capacitance capacitor. This results in that the life of the circuit is determined by, among others, the life of low capacitance capacitor.

In order for the circuit to be used for a long time, the electrolytic capacitor which has reached the end of its life should be replaced with new one. Conventionally, however, the electrolytic capacitor is securely fixed by means of press fitting or soldering.

For example, an electrolytic capacitor disclosed in the Japanese Utility Model Publication No. 3-68386 A comprises a plate-like socket base which has electrically conductive legs extending downward therefrom and a socket cover which is engaged with the socket base to securely hold the electrolytic capacitor mounted on the socket base. The conductive legs have respective holes defined therein for receiving the leads of the electrolytic capacitor. The lower ends of the legs extending coaxially with the leads are securely soldered to the circuit substrate with the socket base spaced away from the substrate.

With the arrangement, the electrolytic capacitor is fixed to and removed from the substrate simply by inserting and drawing the capacitor, respectively. This allows that the electrolytic capacitor which has reached the end of its life can be replaced with a new one and the circuit can be used for the newly replaced capacitor.

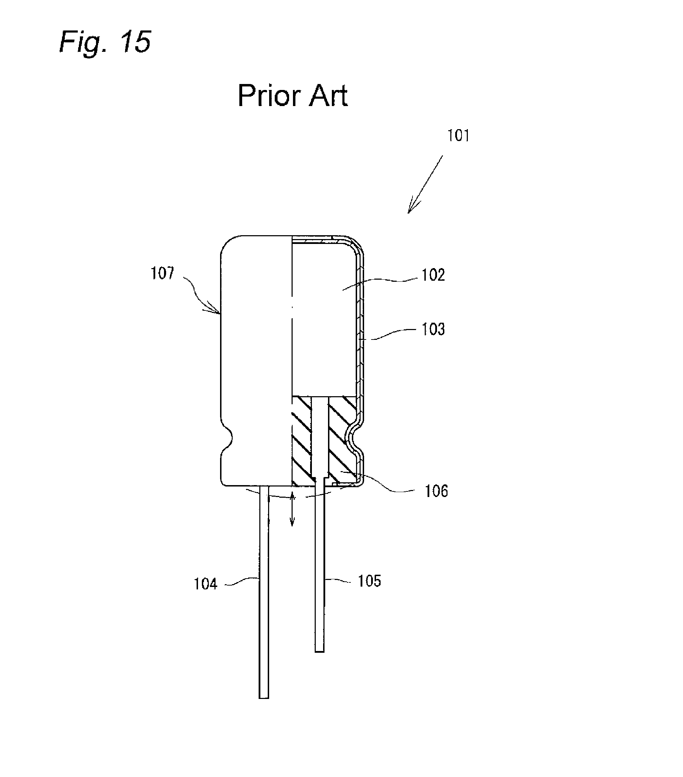

Conventionally, as shown in Fig. 15, the electrolytic capacitor 101 has a housing 103 for accommodating several components and electrolyte. Leads 104 and 105 are extended out through the lower end opening of the housing. The opening is closed by a rubber seal 106. Accordingly, an internal pressure within the housing may increase in response to atmospheric temperature, voltage and ripple current applied thereto or the like. The pressure increase causes an expansion of the rubber seal 106 as indicated in Fig. 15 by an imaginary line. The expanded rubber seal, since it is in contact at its bottom surface with the socket base, forces its housing 107 away from the substrate, which loses a retaining force of the capacitor 101.

The losing of the retaining force results in a reduction of resistance to vibrations, which may in turn degrade the circuit performance including an unwanted dropping of the electrolytic capacitor from the substrate to result in a cancellation of the advantages such as repetitive usage of the circuit.

Accordingly, the present invention is to overcome the disadvantages such as reduction of the retaining force at the pressure increase within the electrolytic capacitor and thereby maintain the effectiveness of the repetitive usage of the circuit.

### SUMMARY OF THE INVENTION

Therefore, a socket for an electrolytic capacitor having a housing and leads extending from a bottom surface of the housing, comprises a support for receiving the bottom surface of the capacitor; and connecting terminals for electrically connecting the leads to a circuit substrate; wherein the support comprises a holder for releasably holding a portion of the housing of the capacitor, the portion being adjacent to the leads, and the support further comprises a recess defined in a top surface of the support for accommodating a deformation of a seal rubber provided at a bottom portion of the housing of the capacitor.

According to the arrangement, the electrolytic capacitor is releasably held by the holder. Also, the holder stabilizes the housing of the electrolytic capacitor and maintains a force for holding the electrolytic capacitor while allowing the deformation of the seal rubber.

Preferably, the support has a groove extending from an outer peripheral surface of the support to the recess. According to this arrangement, air moves through the connecting groove in response to expansions and contractions of the seal rubber, which ensures the expansions and contractions without any restriction and thereby maintains a holding force of the holder in a stable manner.

Preferably, the groove is positioned on a plane connecting the connecting terminals to which the leads are connected. This causes that the connecting groove passes through positions where the leads of the electrolytic capacitor are inserted, so that the groove works as a guide mark when holding the electrolytic capacitor by the holder.

Preferably, the bottom surface of the support defines a contact surface which will be brought into contact with the circuit substrate. This causes that, by the contact of the contact surface with the circuit substrate, the mounted socket is more stabilized to successfully resist vibrations than it is supported by the connecting terminals.

Preferably, the holder has an engaging means for engaging an associated constriction defined at the housing of the capacitor. This allows that the engaging means holds the electrolytic capacitor in a stable manner to prevent the electrolytic capacitor from dropping due to vibrations.

Preferably, the engaging means is made of an engaging spring which is extended downwardly from an upper portion of the holder and is elastically deformable in an inside-outside direction. This allows that the engaging spring is designed to be longer and therefore the capacitor is held firmly while reducing stress applied to the capacitor even for the commercially available products having differences in diameter of the housings thereof and/or in size and shape of the constrictions.

Preferably, each of the connecting terminals has a bottomed-hole into which the lead is inserted and a spring provided at an inner surface of the bottomed-hole for elastically holding the inserted lead. This allows that the spring makes an elastic contact with the lead to establish a reliable electric connection, which reduces a stress to be applied to the lead being inserted. The bottomed-hole prevents a fluid leaked from the capacitor from reaching other portions such as circuit substrate.

As described above, according to the invention, since the electrolytic capacitor can be removed and therefore the circuit can be reused easily. Also, the recess of the support allows the deformations of the seal rubber while maintaining a stable holding of the capacitor by the holder. This in turn prevents the capacitor from dropping and allows the reuse of the capacitor while maintaining a reliable operation of the circuit.

### BRIEF DESCRIPTION OF THE DRAWINGS

Fig. 1 is a cross sectional view of a socket for electrolytic capacitors, showing an operational state of the socket;

Fig. 2 is a perspective view of the socket for electrolytic capacitors;

Fig. 3 is a perspective view of the socket for electrolytic capacitors;

Fig. 4 is a plan view of the socket for electrolytic capacitors;

Fig. 5A is a cross sectional view taken along lines A-A in Fig. 4;

Fig. 5B is a cross sectional view taken along lines B-B in Fig. 4;

Fig. 6A is a cross sectional view showing a relationship between the socket for electrolytic capacitors and the electrolytic capacitor;

Fig. 6B is a cross sectional view showing a relationship between the socket for electrolytic capacitors and the electrolytic capacitor;

Fig. 7 is a side elevational view showing how the electrolytic capacitor is inserted in the socket for electrolytic capacitors;

Fig. 8A is a view showing a process for mounting the socket for electrolytic capacitors;

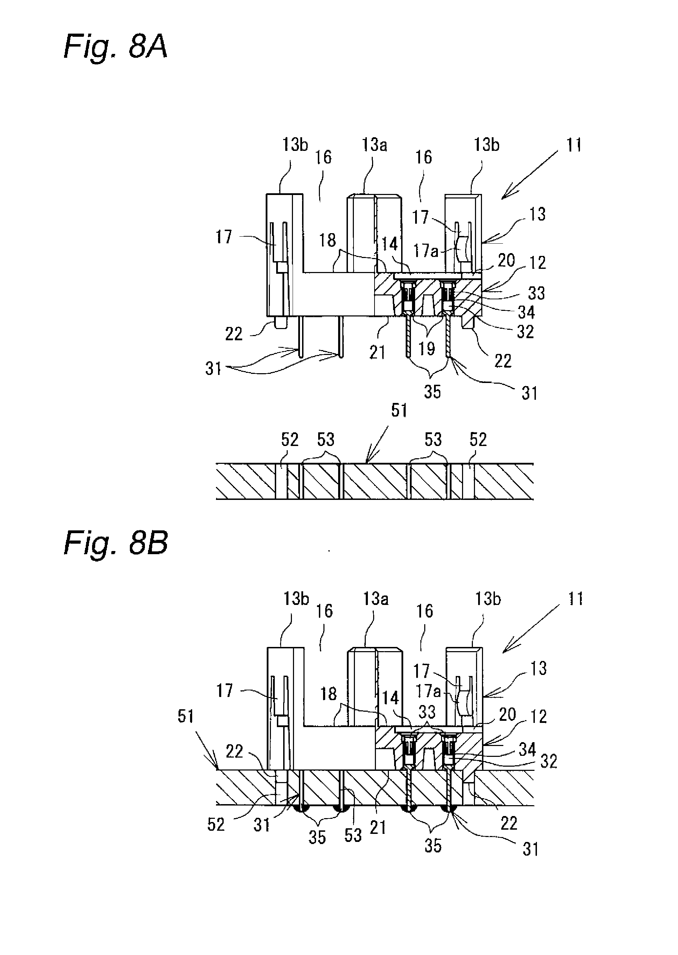

Fig. 8A is a view showing a process for mounting the socket for electrolytic capacitors;

Fig. 8A is a view showing a process for mounting the socket for electrolytic capacitors;

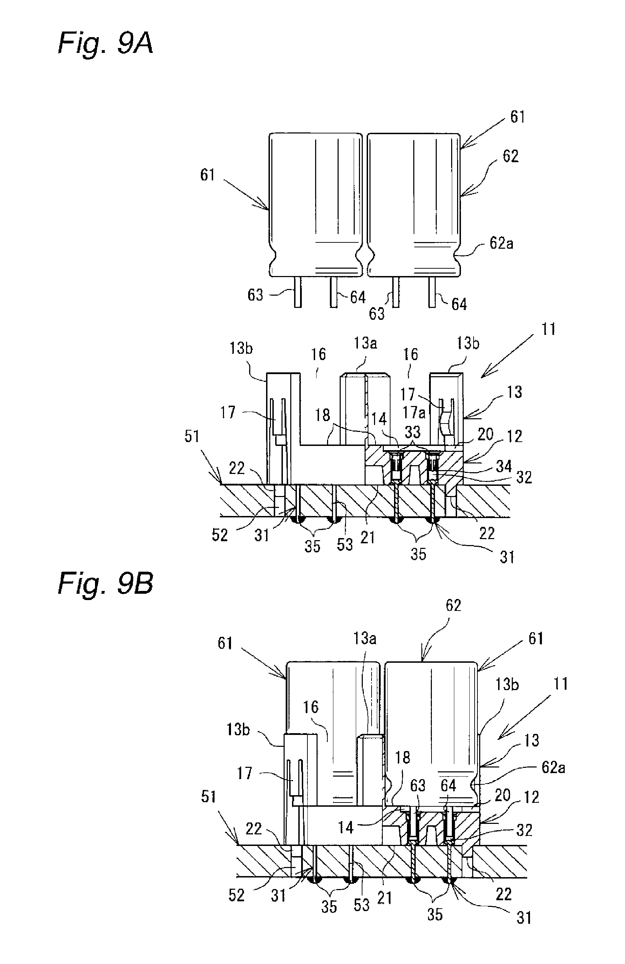

Fig. 9A is a view showing a process for mounting the socket for electrolytic capacitors;

Fig. 9B is a view showing a process for mounting the socket for electrolytic capacitors;

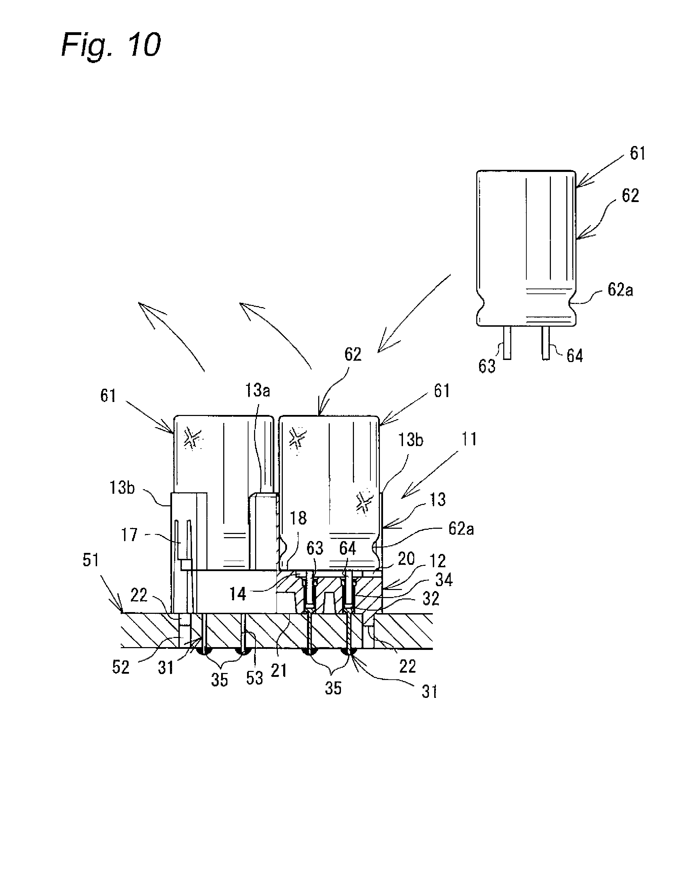

Fig. 10 is a view showing an operational state of the socket for electrolytic capacitors;

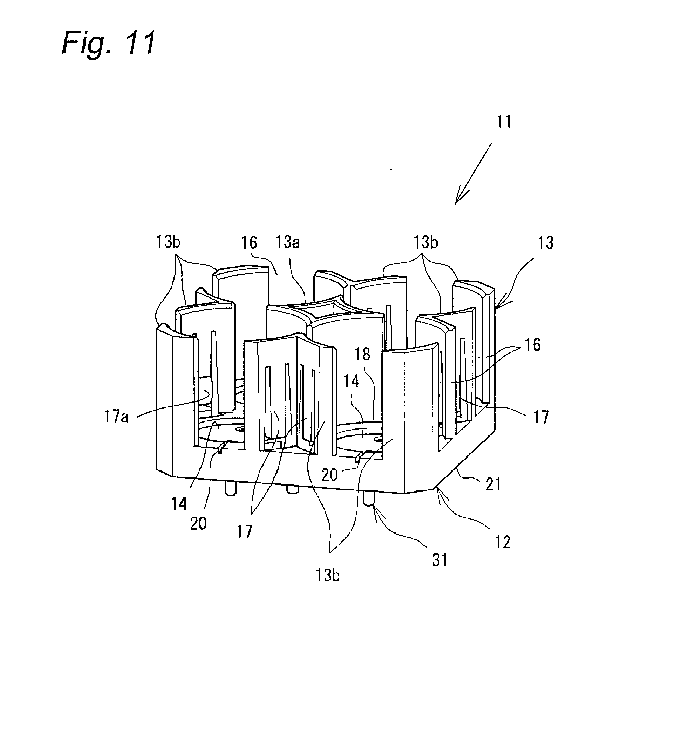

Fig. 11 is a perspective view showing another embodiment of the socket for electrolytic capacitors;

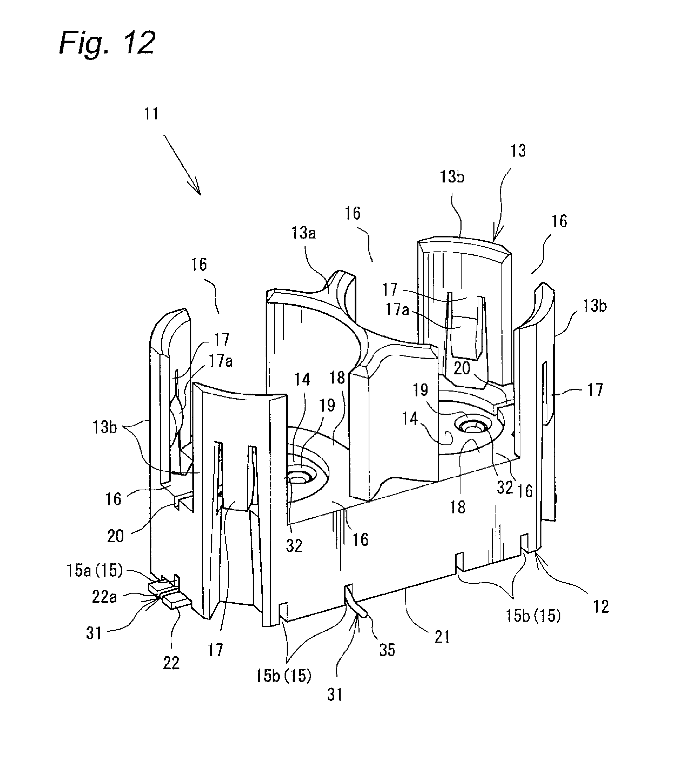

Fig. 12 is a view showing another embodiment of the surface-mounting socket for electrolytic capacitors;

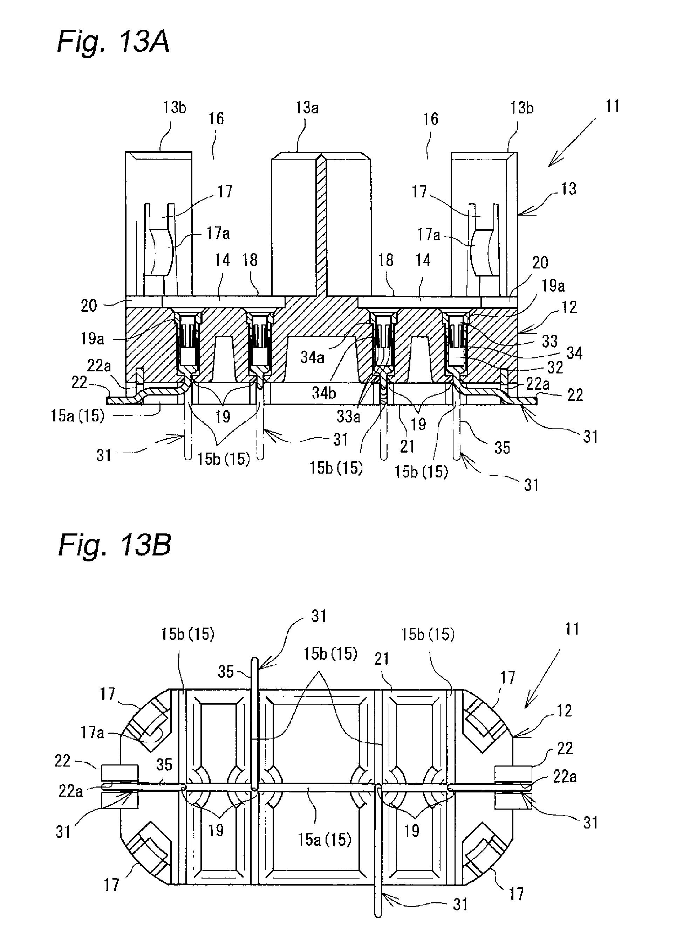

Fig. 13A is a cross sectional view showing the surface-mounting socket for electrolytic capacitors in Fig. 12;

Fig. 13B is a bottom view showing the surface-mounting socket for electrolytic capacitors in Fig. 12;

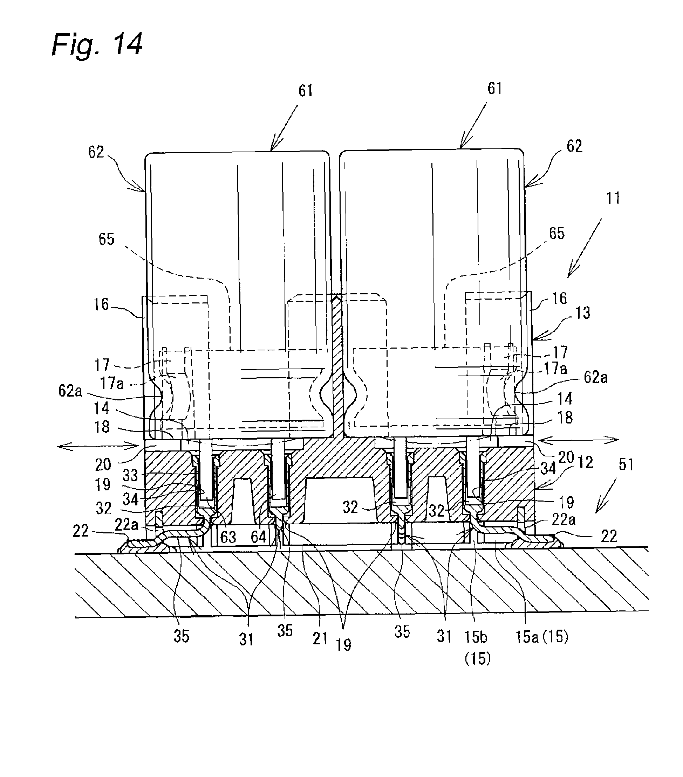

Fig. 14 is a view showing an operational state of the surface-mounting socket for electrolytic capacitors in Fig. 12; and

Fig. 15 is a cross sectional view showing an internal structure of the conventional electrolytic capacitor.

### DETAILED DESCRIPTION OF THE PREFERRED EMBODIMENTS

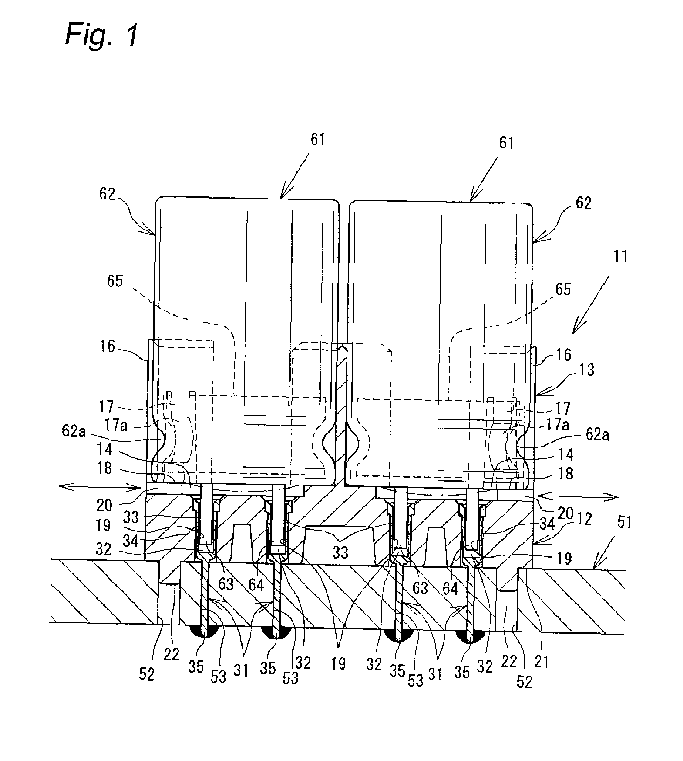

Referring to the accompanying drawings, an embodiment of the invention will be described. Fig. 1 shows a cross sectional view showing an operational state of a socket 11 for electrolytic capacitors. As shown in the drawing, the socket 11 is securely mounted on a circuit substrate 51 by soldering, in which the socket 11 releasably holds electrolytic capacitors 61. Also, the socket 11 is so designed that it can accommodate partial expansions of the capacitors which may be caused by the internal pressure increase in the electrolytic capacitors 61 and thereby maintain their stable holdings. In the embodiment, the electrolytic capacitor 61 is a general purpose capacitor which comprises a housing 62 and two leads 63 and 64 as positive and negative terminals positioned at a bottom portion of the housing 62.

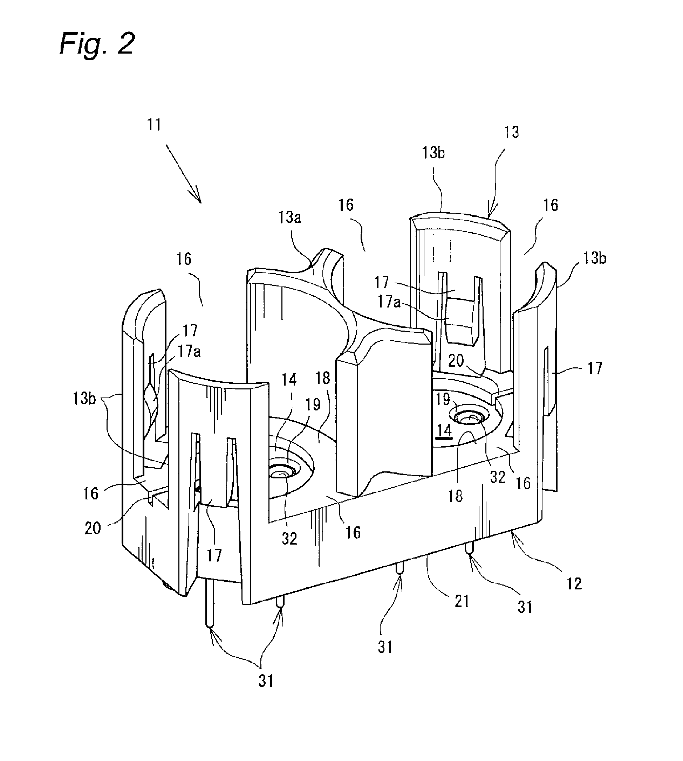

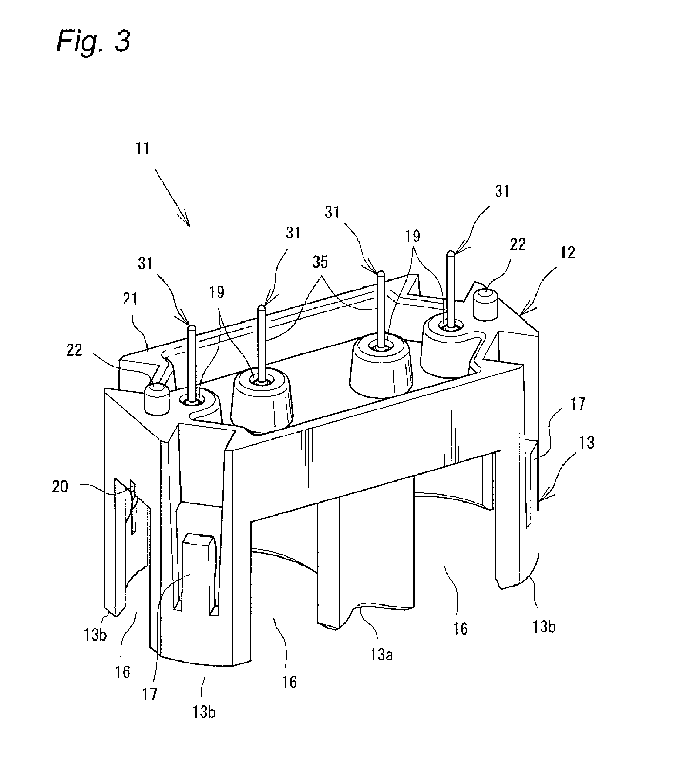

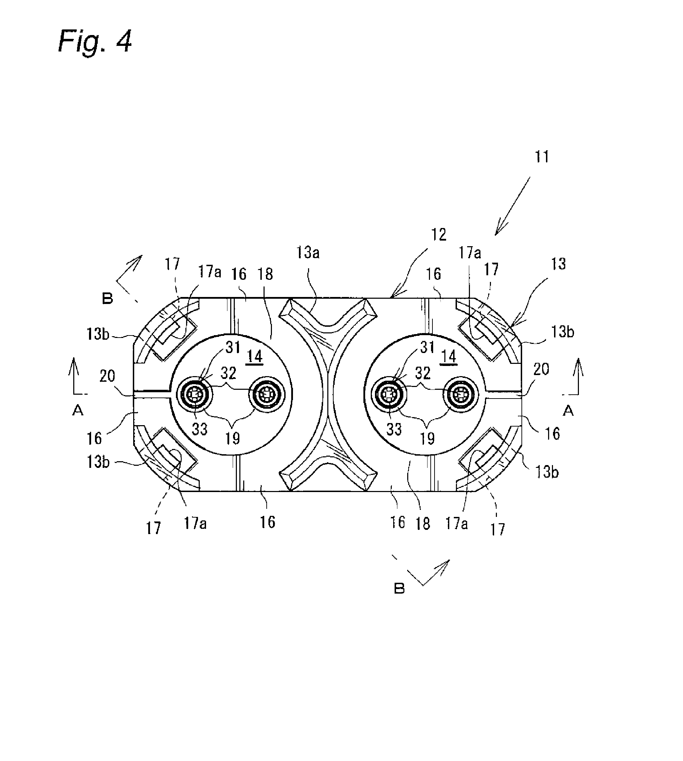

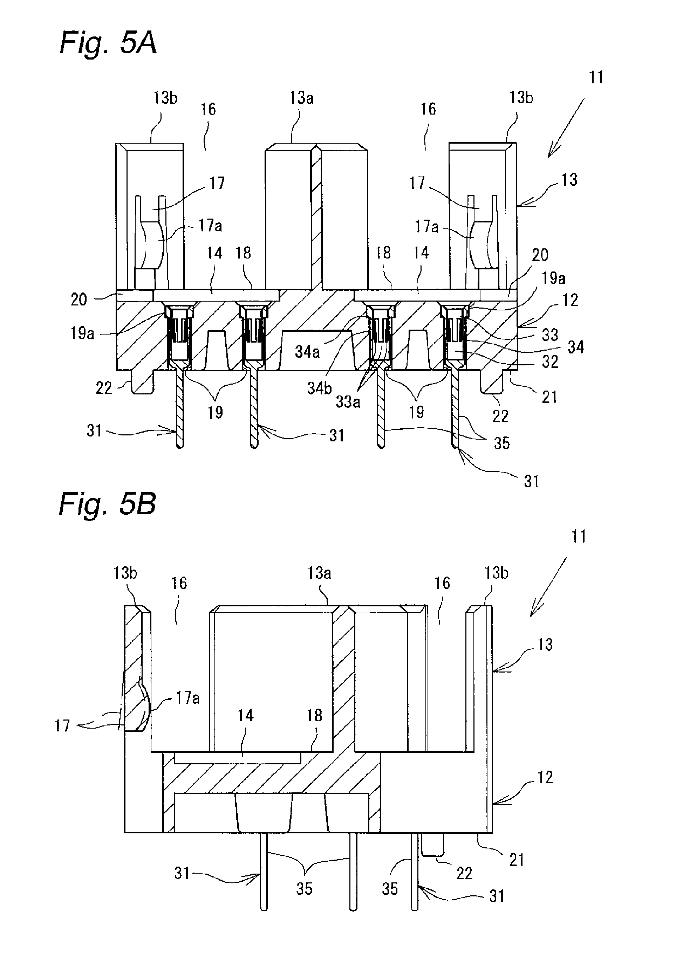

Discussions will be made to a general construction of the socket. Figs. 2 and 3 are perspective views of the socket 11 viewed from its above and below, respectively. Fig. 4 is a plan view and Figs. 5A and 5B are cross sectional views taken along lines A-A and B-B in Fig. 4, respectively. As shown in the drawings, the socket 11 comprises a support 12 for supporting the bottom surface of the housing 62 of the capacitor 61. The support 12 comprises a plurality of connecting terminals 31 for the electrical connections of the leads 63 and 64 extending from the housing 62 of the capacitor 61 to the associated portions of the circuit substrate 51. The support 12 further comprises a holder 13 formed therewith for releasably holding portions of housings 62 of the electrolytic capacitors 61, adjacent to the leads 63, 64. The support 12 also comprises a plurality of recesses 14 formed at the top portions thereof for accommodating expansions of the rubber seals 65 sealingly fitted in respective bottom openings of the housings 62 of the electrolytic capacitors 61 (see Fig. 1).

Specifically, the support 12 and the holder 13 are integrally formed with each other. The support 12 is designed to have substantially a rectangular configuration when viewed from above, which allows that two electrolytic capacitors 61 are arranged side by side on the support 12 with their leads 63 and 64 oriented downwardly. The holder 13 is provided to extend upwardly from peripheral portions of the top surface of the support 12.

Although the holder 13 may be a hollow cylinder capable of surrounding substantially an entire portion of the housing 62 of the electrolytic capacitor 61, as shown in Figs. 2 and 4 it is designed to have a plurality of cutouts 16 in this embodiment. For example, the holder 13 has an inside holder portion 13a provided at an intermediate portion of the support 12 with respect to its longitudinal direction and two pairs of outside holder portions 13b provided at the four corners of the support 12. Also, the inside and outside holder portions 13a and 13b are so arranged to form the cutouts 16 between the inside and outside holder portions 13a and 13b and between the outside holding portions 13b, r respectively, which allows that peripheral three surface portions of each electrolytic capacitor 61 held on the support 12 are exposed between the neighboring holding portions.

Each holder 13 is designed to have a certain height needed for holding the housing 62 of the electrolytic capacitor 61 with a suitable holding force.

Each of the two paired outside holder portions 13b has an engaging means to make a secure engagement with an associated recess or constriction 62a formed in the housing 62 of the electrolytic capacitor 61, allowing the holder to securely hold the housing 62 of the electrolytic capacitor 61.

Although the engaging means may be made of elongated projections formed integrally on an internal peripheral surface of the holder 13, as shown in Fig. 5B it is constituted by engaging springs 17 capable of moving elastically in radial directions in the embodiment. The engaging springs 17 are formed at intermediate portions of outside holder portions 13b with respect to the widthwise directions thereof to extend downwardly from upper portions thereof. The distal ends of the engaging springs 17 have projections 17a integrally formed therewith and projecting inwardly therefrom. The projections 17a are so positioned and sized as to engage with the associated constrictions 62a of the housing 62 of the electrolytic capacitor 61.

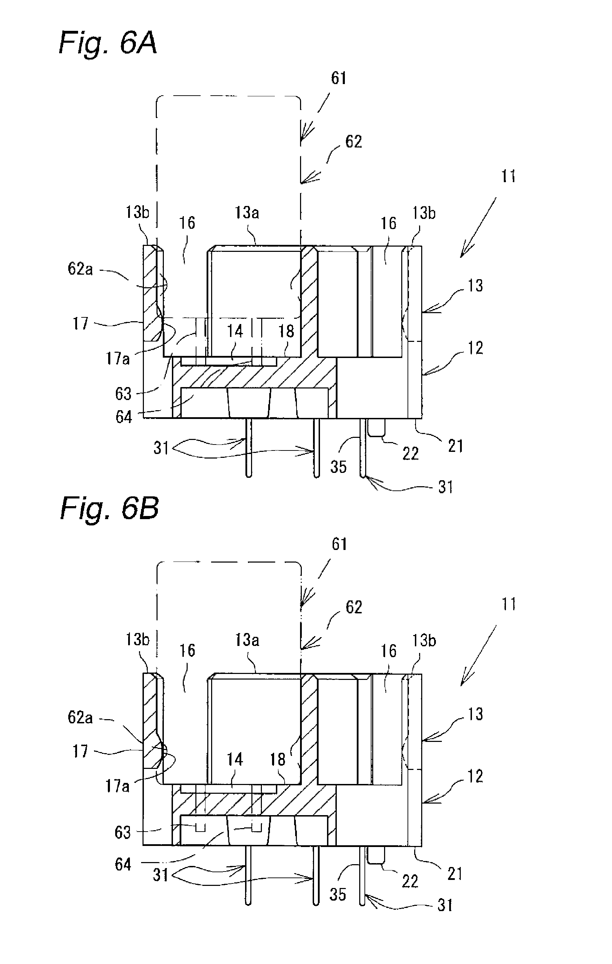

A height and shape of the projections and lengths of the leads 63 and 64 of the electrolytic capacitor 61 are so determined that the projections 17a of the engaging springs 17 do not engage with the associated constrictions 62a when the electrolytic capacitor 61 is not retained firmly as shown in Fig. 6A, but the projections 17a of the engaging springs 17 come to engage with the associated constrictions 62a with click actions when the electrolytic capacitor 61 has been securely retained as shown in Fig. 6B, which ensures a secure mounting of the electrolytic capacitor 61.

The peripheral portions of the support 12 inside the lower ends of the holder 13 so constructed have a flat surface portion 18 for supporting a lower end of the housing 62 of the electrolytic capacitor 61 (see Figs. 1 and 6A, 6B).

The recess 14 is formed inside the supporting surface portion 18 to oppose the lowermost end rubber seal 65 provided at the bottom opening of the housing 62 of the electrolytic capacitor 61 so that it can accommodate the deformation of the seal rubber 65. The recess 14 is circular in shape when viewed from above and has a suitable depth which is determined by an amount of expansion of the seal rubber 65.

An inside bottom surface of the recess 14 has two through holes 19 extending therethrough for receiving the connecting terminals 31 therein. As shown in Fig. 5A, each through hole 19 is so designed that it has an upper larger diameter portion, a lower smaller diameter portion and a step 19a defined therebetween, which allows that the connecting terminal 31 is press fitted and securely held in the through hole 19. As shown in Fig. 4, each pair of through holes 19 are arranged in parallel to each other and spaced away from each other in the longitudinal direction of the support 12.

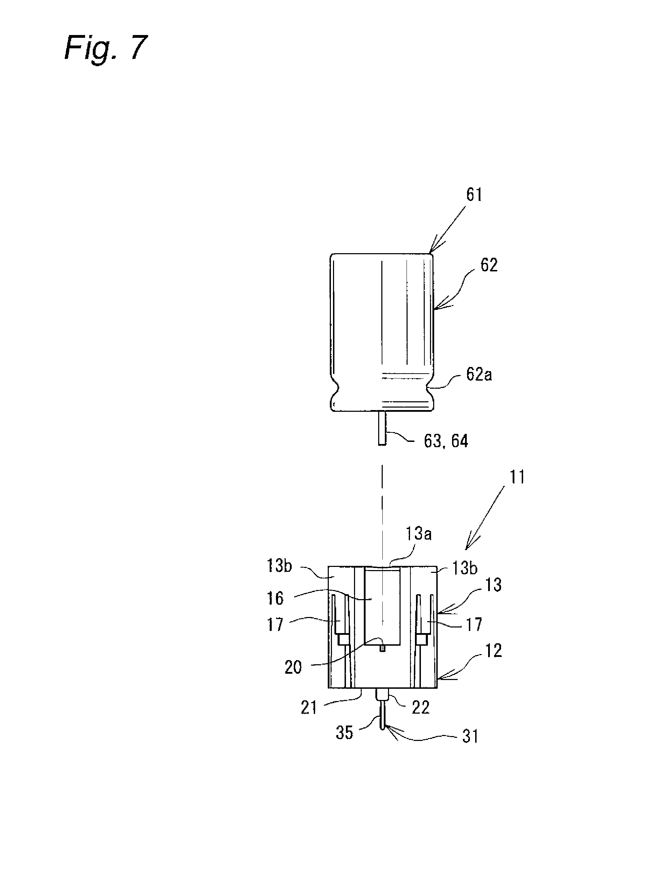

As shown in Figs. 1, 2 and 5A, the support 12 comprises a connecting groove 20 defined therein to extend from the outer peripheral surface of the support 12 to the interior of the recess 14. The connecting groove 20 is configured to have a suitable width and depth and extend linearly along a plane connecting centers of the paired through holes 19. For example, as shown in Figs. 2 and 4, the groove 20 is formed in the support surface portion 18 across the cutout 16 between the neighboring outside holder portions 13b. This arrangement ensures that, as shown in Fig. 7, the leads 63 and 64 of the electrolytic capacitor 61 are aligned with the connecting groove 20 by mounting the electrolytic capacitor 61 in the holder 13.

If the through holes 19 are positioned on a different line, the connecting groove may be extended in that line accordingly.

Further, as shown in Fig. 1, the bottom surface of the support 12 defines a contact surface 21 to be brought into contact with the circuit substrate 51. The contact surface 21 has a pair of press-fitting projections 22 positioned on opposite sides with respect to the longitudinal direction of the support 12 and projecting downwardly (see Fig. 5A). The press-fitting projections 22 are so designed that they are press-fitted in the associated fitting holes 52 defined in the circuit substrate 51.

Each of the connecting terminals 31, which is made of electrically conductive metal material and has a pin-like configuration, has an insert hole 32 in the form of bottomed hole into which the lead is inserted as shown in Fig. 5A. The inner peripheral surface of the hole 32 has springs 33 for elastically holding the lead inserted in the hole 32.

Specifically, the connecting terminal 31 has an upper larger diameter portion 34 and a lower smaller diameter portion 35, both received within the through hole 19. The larger diameter portion 34, which defines the insert hole 32 therein, has a flange 34a which engages with the step 19a of the through-hole 19 and a peg 34b which engages in the smaller diameter portion of the through-hole 19 positioned below the step 19a. Also, the larger diameter portion 34 has substantially cylinder-shaped and downwardly tapered spring 33 integrally formed therewith and made of leaf springs 33a, so that the spring 33 makes a stable contact with the inserted lead 63 or 64 to hold it releasably and securely.

The smaller diameter portion 35 of the connecting terminal 31 is extended straight downwardly beyond the contact surface 21 of the support 12, which allows the through-hole mounting of the socket 11, similar to the lead components (see Fig. 1).

The socket 11 so constructed is securely mounted on a predetermined position of the circuit substrate 51 by soldering for holding the electrolytic capacitors 61.

For this purpose, as shown in Fig. 8A, the circuit substrate 51 comprises through-holes 53 in which the connecting terminals 31 of the socket 11 are received and fitting holes 52 in which the projections 22 on the contact surface 21 of the socket 11 are press-fitted. This allows that the socket 11 is mounted on the circuit substrate 51 so that the connecting terminals 31 and the projections 22 are inserted in the through-holes 53 and the fitting holes 52, respectively. Then, the connecting terminals 31 are soldered by the flowing method (see Fig. 8B). The soldering is simultaneously performed for other circuit components.

The solder mounting of the socket 11 to the circuit substrate 51 causes the contact surface 21 of the support 12 to make a surface contact with the circuit substrate. This cooperates with the press-fittings of the projections to provide the socket with a stable mounting and an elevated resistance to vibrations.

Next, as shown in Fig. 9A, the leads 63 and 64 of the electrolytic capacitor 61 are opposed to the through-holes 19 (i.e., insert holes 32 of the connecting terminal 31) of the socket 11. Then, the leads 63 and 64 are inserted in the insert holes 32 while the housing 62 is received in the holder 13. In this operation, the positive and negative leads are connected to the associated positive and negative connecting terminals, respectively. A modification in which the connecting terminals 31 have different lengths (e.g., the positive terminal is longer than the negative terminal) or any mark is provided at the bottom of the recess 14 ensures a correct connection of the capacitor and the socket without mixing up positive and negative polarities. An automatic mounting of the capacitors 61 ensures the positive and negative leads to be pre-oriented precisely, so that there is no need to provide such marks.

Further, the support 12 has the connecting groove 20 as described above and the groove 20 may work as an appropriate guide for insertion of the capacitor (see Fig. 7).

Furthermore, the insertions of the leads 63 and 64 can be performed without receiving excessive resistance because the peripheral walls of the insertion holes 32 are made of springs 33.

As shown in Fig. 9B, when the electrolytic capacitor 61 is received by the socket 11, the leads 63 and 64 are fully accommodated within the holes 32 of the contact terminals 31 to form stable electric contacts and connections with the contact terminal 31 by the biasing forces from the springs 31 provided in the insert holes 32. Also, the housing 62 of the capacitor 61 is firmly held by the engaging springs 17.

In this condition, the lowermost end surface of the housing 62 is in contact with the receiving surface portion 18 of the support 12 and thereby retained in a stable manner. This ensures an elevated resistance to vibrations, so that no considerable stress will act on the leads 63, 64 even in the vibration environment.

Also, during the insertion of the housing 62 of the capacitor 61 into the holder 13, the engaging springs 17 of the holder 13 are elastically forced outwardly and then the distal projections 17a are clickingly engaged with the constrictions 62a, which provides a comfortable click feeling at the completion of the mounting of the capacitor. This also ensures a stable mounting of the capacitor without causing any excessive stress to the housing 62.

Further, since the engaging springs 17 of the holder 13 are extended downwardly, they can be designed to have a length longer than that when being extended upwardly, which ensures sufficient elastic deformations of the springs. Therefore, the commercially available and widely used electrolytic capacitors 61 can be retained firmly even when they have differences in diameter of the housings 62 and/or in size and shape of the constrictions 62a.

Furthermore, when the internal pressure of the electrolytic capacitor 61 is increased due to heat generated during operations thereof and thereby the seal rubber 65 is deformed by thermal expansion thereof, the deformation is accommodated by the recess 14 of the support to prevent the housing 62 from being raised which would otherwise be caused by the deformation and to ensure a stable holding of the capacitor by the holder 13. Also, a liquid leaked from the capacitor, if any, is received by the recess 13 to prevent the leaked liquid from flowing into contacts with another components or portions. This is also prevented by the fact that the holes 32 of the connecting terminal 31 are designed as bottomed holes.

Moreover, the connecting groove 20 allows air to flow between the recess and the atmosphere, which prevents a pressure increase and decrease in the recess due to the deformations of the seal rubber 65 and an upward movement of the housing 62 which would otherwise be caused thereby. Therefore, the retaining force of the capacitor is maintained reliably.

As shown in Figs. 10A and 10B, the deteriorated capacitors 61 can be dismounted from the socket 11 and replaced by new ones. The circuit on the circuit substrate can be used with the new capacitors, so that the circuit substrate 51 does not need to be discarded with the deteriorated capacitor.

As described above, the capacitor 61 can be retained in a stable manner irrelevant to the deformations caused in the capacitor. Also, the capacitor 61 can work without being affected by vibrations. Further, the liquid leaked from the capacitor is prohibited from flowing into contact with other components. Therefore, the circuit is well reused for the newly replaced capacitors.

Other modifications will be described below. In the following descriptions, like parts are designated by like reference numerals and therefore no descriptions will be duplicated for those parts.

Fig. 11 shows a socket 11 for which four electrolytic capacitors can be mounted. As shown in the drawing, the support 12 and the holder 13 are suitably configured to receive a required number of electrolytic capacitors.

Fig. 12 is a perspective view of another socket 11 for surface-mounting, rather than through-hole mounting. As shown in Fig. 13 A, the socket 11 comprises a plurality of grooves 15 defined in the bottom surface of the support 12 for receiving and guiding angled and horizontally oriented smaller diameter portions 35 of the connecting terminals 31. As shown in Fig. 13B, the guide grooves 15 are provided for respective through-holes 19, i.e., one guide groove 15a extending in a longitudinal direction of the support 12 and four guide grooves 15b extending in a transverse direction of the support 12.

The opposite end portions of the contact surface 21 of the support 12 with respect to the longitudinal direction carry L-shaped fixing brackets 22 fixed thereto. The fixing clamps 22 are fixed at the mounting of the socket 11. Each fixing bracket 22 has a cutout 22a formed therein to define the guide groove 15a.

The socket 11 so constructed is mounted on the surface of the circuit substrate 51 by the reflow soldering, to which the electrolytic capacitors are mounted. Therefore, as shown in Fig. 14, the recess 14 works as described above and attains the advantages described above. Also, according to the embodiment, high capacitance capacitors can be surface-mounted. Further, the capacitors can be well protected from heat at the reflow soldering.

In the above-described arrangements and structures according to the several embodiments, the engaging means corresponds to the engaging spring 17 but it is not limited thereto and other modifications can be contemplated and employed. For example, the number and/sizes of the electrolytic capacitors to be mounted on the socket are suitably determined.

Also, instead of the connecting terminals described above, another structure having a leaf spring, for example, and capable of retaining the leads may be used.

## Claims

1. A socket for an electrolytic capacitor comprising a housing and leads extending from a bottom surface of the housing, comprising:
a support for receiving the bottom surface of the capacitor; and
connecting terminals for electrically connecting the leads to a circuit substrate;
wherein
the support comprises a holder for releasably holding a portion of the housing of the capacitor, the portion being adjacent to the leads,
the support further comprises a recess defined in a top surface of the support for accommodating a deformation of a seal rubber provided at a bottom portion of the housing of the capacitor.

2. The socket of claim 1, wherein the support has a groove extending from an outer peripheral surface of the support to the recess.

3. The socket of claim 2, wherein the groove is positioned on a plane connecting the connecting terminals to which the leads are connected.

4. The socket in any one of claims 1-3, wherein the support has a bottom surface which defines a contact surface which will make a contact with the circuit substrate.

5. The socket in any one of claims 1-4, wherein the holder has an engaging means for engaging an associated recess defined at the housing of the capacitor.

6. The socket of claim 5, wherein the engaging means is made of an engaging spring which is extended downwardly from an upper portion of the holder and is elastically deformable in an inside-outside direction.

7. The socket in any one of claims 1-6, wherein each of the connecting terminals has a bottomed-hole into which the lead is inserted and a spring provided at an inner surface of the bottomed-hole for elastically holding the inserted lead.
